# EUROPEAN PATENT APPLICATION

(11) **EP 2 648 312 A1**
(43) Date of publication of application: **09.10.2013**
(21) Application number: 11845496.6
(22) Date of filing: 20.10.2011
(51) Int. Cl.: H02J 13/00, G01D 7/00, G01R 11/00, G06F 1/28, G06F 13/00, G06Q 10/00, G06Q 50/26

(54) **PHYSICAL-QUANTITY INFORMATION PROVIDING SYSTEM, MEASUREMENT APPARATUS, MOBILE INFORMATION TERMINAL, METHOD OF PROVIDING PHYSICAL-QUANTITY INFORMATION, METHOD OF CONTROLLING MEASUREMENT APPARATUS, METHOD OF CONTROLLING MOBILE INFORMATION TERMINAL, AND CONTROL PROGRAM**

(30) Priority: 02.12.2010 JP 2010269331
(71) Applicant: Omron Corporation, Kyoto-shi, Kyoto 600-8530 (JP)
(72) Inventor: MISUMI, Shuichi, Kyoto-shi, Kyoto 600-8530 (JP)
(74) Representative: Barth, Stephan Manuel
(86) International application number: PCT/JP2011/074117
(87) International publication number: WO 2012/073610

(57) **Abstract**

Sensors (4, 5) are provided with information transmission units for transmitting power information to a mobile information terminal (6) and a server (9). The server (9) is provided with a server storage unit that stores power information for the duration of a second period. The mobile information terminal (6) is provided with: a terminal storage unit that stores power information for the duration of a first period that is shorter than the second period; a power information acquisition unit that acquires power information from the terminal storage unit or the server (9), in accordance with a display period specified by a user; and a display control unit that displays the acquired power information.

## Description

### TECHNICAL FIELD

The present invention relates to a physical-quantity information providing system that provides information on a power or the like to a user.

### BACKGROUND ART

Nowadays, environmental issues are raised, and reduction of an environmental load, namely, reduction of a consumed power is strongly demanded to a user who uses household electrical appliances. A HEMS (Home Energy Management System) is well known as a system managing the household consumed power. For example, in the HEMS, data of each household consumed power is transmitted to a server installed in a data center. The user can check a consumed power quantity by accessing the server through the Internet. There is proposed an electric quantity monitoring apparatus and the like, with which the user can recognize the power quantity consumed by each electrical appliance (see Patent Documents 1 to 3).

The electric quantity monitoring apparatus disclosed in Patent Document 1 includes a power plug and a plurality of taps, measures a current passed through each tap, and obtains the electric quantity such as the power and the consumed power quantity based on the current, and monitors the electric quantity consumed by the electrical appliance. The electric quantity monitoring apparatus transmits monitoring information to a server device or a personal computer through a LAN cable. Therefore, the consumed power of the electrical appliance connected to the tap can be monitored on the server device or personal computer.

A power control system disclosed in Patent Document 2 includes a power control device, a status notification device, and a television set. The power control device includes a communication processing unit connected to a first communication medium (wireless) and a power calculation unit that senses a total power, and the power control device monitors the power used in home. The status notification device includes a first communication processing unit connected to the first communication medium, a second communication processing unit connected to a second communication medium (LAN cable), and a web server function unit. The television set includes a web browser function and a communication processing unit connected to the second communication medium. The status notification device catches a content of communication between the household electrical appliance with the communication function or the adapter and the power control device through the first communication medium, and displays current power used status on the television from the second communication processing unit. Therefore, before a breaker shuts down the power because the consumed power in home exceeds an upper limit, the current passed through each electrical appliance can be stopped, or a warning that the consumed power comes close to the upper limit can be displayed on the television set.

An environmental load information providing system disclosed in Patent Document 3 includes an environmental load measurement apparatus and a remote controller. The environmental load measurement apparatus is inserted between a power plug of the television set and an electric outlet, calculates an environmental load generated during the use of the television set from the consumed power, and transmits an environmental load value to a remote controller. The remote controller operates the television set, and displays the environmental load value calculated by the environmental load measurement apparatus on an LCD. Therefore, the user can check the environmental load value of the television set on the LCD of the remote controller.

### PRIOR ART DOCUMENTS

### PATENT DOCUMENTS

Patent Document 1: Japanese Unexamined Patent Publication No. 2008-261826
Patent Document 2: Japanese Unexamined Patent Publication No. 2010-161848
Patent Document 3: Japanese Unexamined Patent Publication No. 2008-003843

### SUMMARY OF THE INVENTION

### PROBLEMS TO BE SOLVED BY THE INVENTION

However, the following problems are generated in the conventional configurations.

In the configuration of Patent Document 1, in the case that the electric quantity monitoring apparatus transmits the monitoring information such as the consumed power quantity to the personal computer, it is necessary that the personal computer be running. Therefore, in the case that the user wants to check the consumed power quantity of the electrical appliance in real time, it is necessary that the personal computer be always running, which results in an increase in consumed power. Even for non-real time checking, it is necessary to start up the personal computer in order to check the consumed power quantity of the electrical appliance. Therefore, the user cannot easily check the consumed power quantity of the electrical appliance.

Another problem is generated in the case that the monitoring information such as the consumed power quantity is transmitted to the server device. In the case that the electric quantity monitoring apparatus of each house transmits the monitoring information to the server device to collectively monitor the household consumed power quantities on the server device, the accesses from the electric quantity monitoring apparatuses of the houses to the server device aggregate on the server device. Possibly the server device goes down when the electric quantity monitoring apparatuses frequently transmit the pieces of monitoring information to the server device. In order that the access aggregation is avoided while a cost of the server device is suppressed, actually the electric quantity monitoring apparatus collectively transmits the pieces of monitoring information to the server device with a long interval between transmissions. Therefore, sometimes a variation in household consumed power does not quickly reflect the data of the server device.

On the other hand, in order to encourage the user to save the consumed power, it is necessary that the user can quickly check the variation in consumed power. For example, it is assumed that the user turns off the power of the electrical appliance for the purpose of energy saving. At this point, when the user can quickly recognize a result (a decrease in consumed power) of the saving, the user easily realizes an energy saving effect, and motivation of energy saving action can be provided to the user. However, in the configuration of Patent Document 1, it is difficult to instantly transmit the variation in household consumed power to the server device to present the current variation in consumed power to the user.

In the configuration of Patent Document 2, the status notification device displays a power used status on the personal computer or the television set. Therefore, in order to check the consumed power, it is necessary for the user to start up the personal computer or the television set, and the user cannot easily check the consumed power quantity of the electrical appliance. A cost for introduction of the status notification device including the function of displaying the information on the personal computer or the television set is also required in addition to the adaptor that measures the consumed power of the electrical appliance.

In the configuration of Patent Document 3, the environmental load value is stored in the remote controller of the television set. However, a large-capacity storage device is required to store the data of the environmental load value accumulated for a long time. When the large-capacity storage device is incorporated in the remote controller, the introduction cost increases. Therefore, realistically the last short-period environmental load value can be checked with the remote controller.

In the HEMS in which the consumed power and the like are managed using the server, the user can advantageously introduce the system at low cost, while disadvantageously the frequency of the data transmission from the house to the server cannot be increased in order to avoid the aggregation of the load on the server. Therefore, the user cannot quickly check the effect of the energy saving action. Sometimes the user mistakenly perceives the long transmission interval as communication interruption. Unlike adjustment of cooling and heating in which the user can quickly feel the action, for example, the user cannot feel the effect to turn off a standby power unless the user checks the consumed power. When the user cannot quickly check the effect after turning off the standby power, the user is easily uninterested in the energy saving action due to the trouble of having to turn off a switch.

The present invention has been devised to solve the problems described above, and an object thereof is to construct a physical-quantity information providing system, in which the introduction cost is reduced, the user can quickly check the variation in physical quantity such as the consumed power of the electrical appliance, and the user can check recording of the long-period physical quantity.

### MEANS FOR SOLVING THE PROBLEM

In accordance with a first aspect of the present invention to solve the problems described above, a physical-quantity information providing system that provides physical-quantity information to a user, the physical-quantity information indicating a physical quantity changing with time, the physical-quantity information providing system includes: a first storage unit in which the physical-quantity information in a first period is stored; a second storage unit in which the physical-quantity information in a second period different from the first period is stored; an instruction input unit that receives a designation of a display period from the user, the designation of the display period indicating display of the physical-quantity information in the first or second period; an information acquisition unit that specifies acquisition of the physical-quantity information from the first or second storage unit according to the display period designated by the user, and acquires the physical-quantity information from the specified storage unit; and a display control unit that controls the display of the physical-quantity information acquired by the information acquisition unit.

In accordance with a second aspect of the present invention to solve the problems described above, a physical-quantity information providing method of providing physical-quantity information to a user, the physical-quantity information indicating a physical quantity changing with time, the physical-quantity information providing method includes: a first storage step of storing the physical-quantity information in a first period in a first storage unit; a second storage step of storing the physical-quantity information in a second period different from the first period in a second storage unit; an instruction input step of receiving a designation of a display period from the user, the designation of the display period indicating display of the physical-quantity information in the first or second period; an information acquisition step of specifying acquisition of the physical-quantity information from the first or second storage unit according to the display period designated by the user, and acquiring the physical-quantity information from the specified storage unit; and a display control step of controlling the display of the physical-quantity information acquired in the information acquisition step.

In accordance with a third aspect of the present invention to solve the problems described above, a mobile information terminal that can conduct communication with a measurement apparatus and an information processing apparatus, the mobile information terminal includes: a receiving unit that receives physical-quantity information from the measurement apparatus, the physical-quantity information indicating a physical quantity measured by the measurement apparatus; a first storage unit in which the received physical-quantity information is stored; an instruction input unit that receives a designation of a display period from the user, the designation of the period indicating display of the physical-quantity information in the period; an information acquisition unit that specifies acquisition of the physical-quantity information from the first storage unit or a second storage unit included in the information processing apparatus according to the display period designated by the user, and acquires the physical-quantity information from the specified storage unit; and a display control unit that controls the display of the physical-quantity information acquired by the information acquisition unit.

In accordance with a fourth aspect of the present invention to solve the problems described above, a method of controlling a mobile information terminal that can conduct communication with a measurement apparatus and an information processing apparatus, the mobile information terminal controlling method includes: a receiving step of receiving physical-quantity information from the measurement apparatus, the physical-quantity information indicating a physical quantity measured by the measurement apparatus; a first storage step of storing the received physical-quantity information in a first storage unit included in the mobile information terminal; an instruction input step of receiving a designation of a display period from the user, the designation of the display period indicating display of the physical-quantity information in the designated period; an information acquisition step of specifying acquisition of the physical-quantity information from the first storage unit or a second storage unit included in the information processing apparatus according to the display period designated by the user, and acquiring the physical-quantity information from the specified storage unit; and a display control step of controlling the display of the physical-quantity information acquired in the information acquisition step.

In accordance with a fifth aspect of the present invention to solve the problems described above, a measurement apparatus that can conduct communication with a mobile information terminal and an information processing apparatus, the measurement apparatus includes: a physical-quantity measurement unit that measures a physical quantity changing with time; a physical-quantity information generation unit that generates physical-quantity information indicating the physical quantity; and an information transmission unit that transmits the physical-quantity information to the mobile information terminal in each third period, and transmits the physical-quantity information to the information processing apparatus in each fourth period longer than the third period.

In accordance with a sixth aspect of the present invention to solve the problems described above,, a method of controlling a measurement apparatus that can conduct communication with a mobile information terminal and an information processing apparatus, the measurement apparatus controlling method includes: a physical-quantity measurement step of measuring a physical quantity changing with time; a physical-quantity information generation step of generating physical-quantity information indicating the physical quantity; and an information transmission step of transmitting the physical-quantity information to the mobile information terminal in each third period, and transmitting the physical-quantity information to the information processing apparatus in each fourth period longer than the third period.

According to the configuration, the first storage unit in which the physical-quantity information in the first period is stored and the second storage unit in which the physical-quantity information in the second period is stored can share roles. Therefore, one of the storage units can be used as means for storing the last physical-quantity information while the other storage unit is used as means for storing the past physical-quantity information. For this reason, for example, when one of the storage units is incorporated in the mobile information terminal while the other storage unit is incorporated in the information processing apparatus, a communication load on the information processing apparatus can be reduced. Therefore, the introduction cost of the physical-quantity information providing system can be reduced.

### EFFECT OF THE INVENTION

As described above, according to the present invention, the first storage unit and the second storage unit can share roles. Therefore, one of the storage units can be used as means for storing the last physical-quantity information while the other storage unit is used as means for storing the past physical-quantity information. For this reason, for example, when one of the storage units is incorporated in the mobile information terminal while the other storage unit is incorporated in the information processing apparatus, the communication load on the information processing apparatus can be reduced. Therefore, the introduction cost of the physical-quantity information providing system can be reduced.

### BRIEF DESCRIPTION OF THE DRAWINGS

Fig. 1 is a view illustrating an outline of a configuration of a power information providing system according to an embodiment of the present invention.
Fig. 2 is a block diagram illustrating a functional configuration of a sensor of the power information providing system.
Fig. 3 is a block diagram illustrating a functional configuration of a server of the power information providing system.
Fig. 4 is a view illustrating second power information stored in a server storage unit.
Fig. 5 is a block diagram illustrating a functional configuration of a mobile information terminal of the power information providing system.
Fig. 6 is a view illustrating first power information stored in a terminal storage unit.
Fig. 7 is a flowchart illustrating a processing flow in the sensor.
Fig. 8 is a flowchart illustrating a processing flow in the mobile information terminal.
Fig. 9(a) is a view illustrating a display example of power information on last 2 hours, and Fig. 9(b) is a view illustrating a display example of power information on last 18 hours.

### MODE FOR CARRYING OUT THE INVENTION

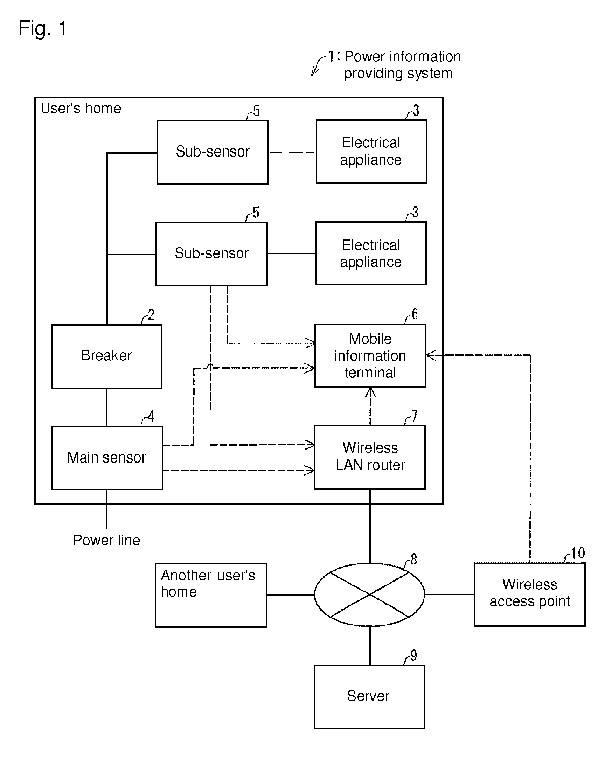

Hereinafter, an embodiment will be described in detail with reference to Figs. 1 to 9.

### <Configuration of power information providing system>

Fig. 1 is a view illustrating an outline of a configuration of a power information providing system 1 according to an embodiment. The power information providing system (the physical-quantity information providing system) 1 provides power information such as a consumed power used in a user's home to the user. A power line through which the power is supplied from the outside is routed to the user's home, and the power line is connected to a breaker 2. A plurality of wirings are placed from the breaker 2 into the user's home, and various electrical appliances 3 are connected to the wirings and used.

The power information providing system 1 includes a main sensor (the measurement apparatus) 4, a plurality of sub-sensors (the measurement apparatus) 5, a mobile information terminal 6, a wireless LAN router 7, and a server (the information processing apparatus) 9 connected to the Internet 8. The main sensor 4, the plurality of sub-sensors 5, and the wireless LAN router 7 are installed in the user's home.

The main sensor 4 is disposed between the power line routed into the user's home and the breaker 2, and the main sensor 4 measures a current and a voltage or the power of the breaker 2.

The sub-sensor 5 includes a power plug and a tap, the power plug is connected to an outlet in the user's home, and the power is supplied to the electrical appliance 3 connected to the tap. The sub-sensor 5 measures the current, the voltage, and the power of the electrical appliance 3 connected to the tap.

The main sensor 4 and the sub-sensor 5 have a wireless communication function, and transmit the power information such as the measured power to the mobile information terminal 6 owned by the user through an ad hoc connection. The main sensor 4 and the sub-sensor 5 transmit the power information to the server 9 through the wireless LAN router 7. Any system can be used in the wireless communication. For example, a mobile information terminal and a wireless LAN router, which are compliant with a WiFi (registered trademark) standard, become increasingly common, and the wireless communication can be conducted using the WiFi-compliant mobile information terminal and wireless LAN router.

The wireless LAN router 7 is one that generally becomes widespread in order to wirelessly connect a personal computer to the Internet. The personal computer is not illustrated herein.

A wireless access point 10 is a wireless access point (antenna base station) that is used to make a phone call or network communication using a mobile phone. The wireless access point 10 is connected to the Internet 8.

### <Configuration of sensor>

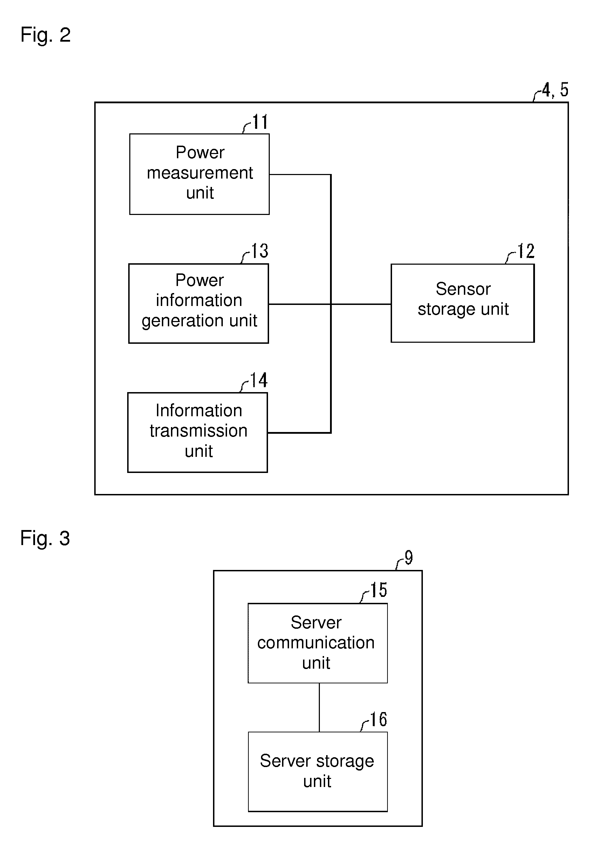

Fig. 2 is a block diagram illustrating a functional configuration of a sensor 4/5. Because the main sensor 4 and the sub-sensor 5 have the function of measuring the power and the like to transmit the power information to the outside, hereinafter the main sensor 4 and the sub-sensor 5 are collectively described as a sensor 4/5. The sensor 4/5 includes a power measurement unit (the physical-quantity measurement unit) 11, a sensor storage unit 12, a power information generation unit (the physical-quantity information generation unit) 13, and an information transmission unit 14.

The power measurement unit 11 measures the currents passed through the electrical appliances 3 connected to the sensor 4/5 and the voltages applied to the electrical appliances 3, thereby measuring the powers used in the electrical appliances 3. In the case that the sensor 4/5 is disposed between the electrical appliances 3 and the breaker 2 like the main sensor 5, the power measurement unit 11 measures a total of powers used in all the electrical appliances 3 connected to the sensor 4/5. The power measurement unit 11 may measure only the current, and obtain the power by multiplying the current by a rated voltage. The power measurement unit 11 measures the power on a steady basis or at relatively short predetermined time intervals (for example, every 1 second), and stores data of the measured power in the sensor storage unit 12.

The power information generation unit 13 acquires the data of the power from the sensor storage unit 12 to obtain an average power in each predetermined first period (for example, for 15 seconds). The power information generation unit 13 stores the average power in the first period as first power information in the sensor storage unit 12 while correlating the average power in the first period with information on the first period (a measurement clock time and a measurement period). The power information generation unit 13 acquires the data of the power from the sensor storage unit 12 to obtain an average power in each predetermined second period (for example, for 10 minutes) longer than the first period. The power information generation unit 13 stores the average power in the second period as second power information in the sensor storage unit 12. The power information generation unit 13 may obtain a consumed power quantity or an average current in a predetermined period, and use the consumed power quantity or average current in the predetermined period as the power information. The power information generation unit 13 may use an amount of carbon dioxide emission, which is obtained by multiplying the consumed power quantity by a predetermined coefficient, as the power information. The amount of carbon dioxide emission is one of indexes indicating the power used in the electrical appliance.

The information transmission unit 14 wirelessly conducts communication with the mobile information terminal 6 and the wireless LAN router 7. The information transmission unit 14 acquires the first power information from the sensor storage unit 12 in each first period (15 seconds), and transmits the first power information to the mobile information terminal 6 of the user. The information transmission unit 14 acquires the second power information from the sensor storage unit 12 in each second period (10 minutes), and transmits the second power information to the server 9, which is previously ser by a manufacturer or the user, through the wireless LAN router 7. The information transmission unit 14 transmits the corresponding measurement clock time and measurement period (a time width), a user ID, and a sensor ID to the server 9 together with the first power information.

In case that the first or second power information cannot be transmitted to the mobile information terminal 6 or the server 9 due to a communication environment or the like, the sensor storage unit 12 retains the first power information and second power information, which are not transmitted yet, as recovery data for retransmission.

### <Configuration of server>

Fig. 3 is a block diagram illustrating a functional configuration of the server 9. The server 9 includes a server communication unit 15 and a server storage unit 16. The server 9 is connected to the Internet.

The server communication unit 15 conducts communication with the main sensor 4, the sub-sensor 5, and the mobile information terminal 6 through the Internet. When receiving the second power information from the main sensor 4 or sub-sensor 5, the server communication unit 15 stores the second power information in the server storage unit 16. The server 9 is used by a plurality of users, and pieces of second power information transmitted from a plurality of sensors of different user's homes are stored in the server storage unit 16. The server communication unit 15 that receives a request of the second power information from the mobile information terminal 6 transmits the second power information on the corresponding user and sensor to the mobile information terminal 6.

The second power information transmitted periodically (every 10 minutes) from the sensor 4/5 is stored in the server storage unit 16. For example, the received pieces of second power information to one year ago from the most recent clock time (the measurement clock time of the power) are stored in the server storage unit 16. That is, about 52560 pieces of second power information on each sensor of the most recent one year are stored in the server storage unit 16 with a time step of the second period (10 minutes).

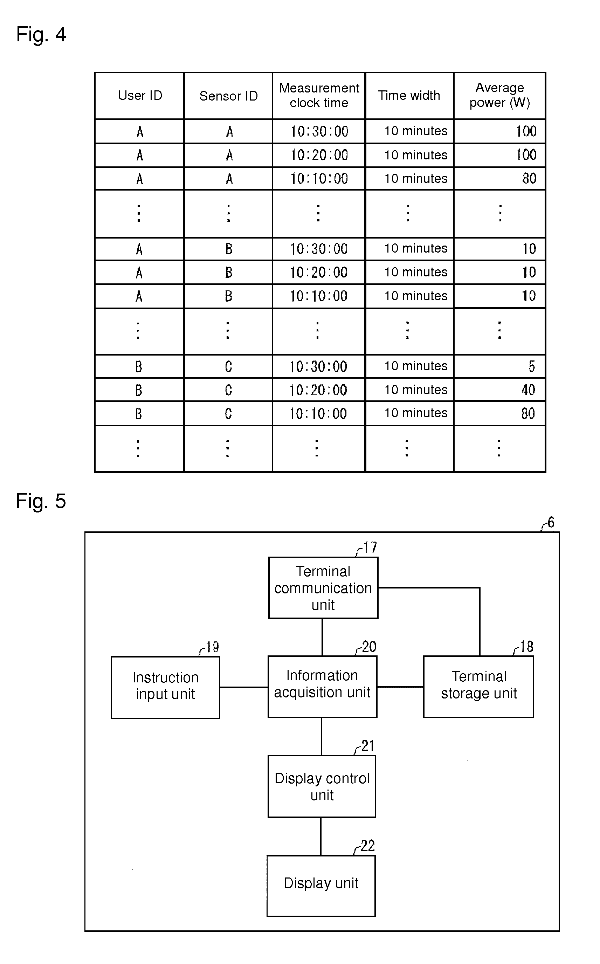

Fig. 4 is a view illustrating the second power information stored in the server storage unit 16. The pieces of second power information on the plurality of sensors are stored in the server storage unit 16 with respect to the plurality of users. A user ID, a sensor ID, the measurement clock time, a time width of the second period, and an average power of the second period are stored in the server storage unit 16 while correlated with one another.

### <Configuration of mobile information terminal>

Fig. 5 is a block diagram illustrating a functional configuration of the mobile information terminal 6. The mobile information terminal 6 is one that includes a display function and the wireless communication function (for example, the WiFi communication function). A prevalent mobile phone terminal like a smartphone can be used as hardware of the mobile information terminal 6. The mobile information terminal 6 of the embodiment implements the function of providing the power information to the user by a power information providing application installed in the mobile information terminal 6. In the power information providing application, a program to receive the power information from the sensor 4/5 is resident in memory and operates to receive the power information periodically transmitted from the sensor 4/5. In the case that the user is worried about battery drain, a receiving operation may be performed only in recharge. The mobile information terminal 6 includes a terminal communication unit (the receiving unit) 17, a terminal storage unit 18, an instruction input unit 19, an information acquisition unit (the physical-quantity information acquisition unit) 20, a display control unit 21, and a display unit 22.

The terminal communication unit 17 wirelessly conducts communication with the sensor 4/5, the wireless LAN router 7, and the wireless access point 10. The terminal communication unit 17 receives the first power information transmitted periodically (every 15 seconds) from the sensor 4/5, and stores the received first power information in the terminal storage unit 18. The terminal communication unit 17 acquires the second power information from the server 9 in response to the instruction from the information acquisition unit 20, and outputs the second power information to the information acquisition unit 20. The terminal communication unit 17 may store the acquired second power information in the terminal storage unit 18.

The first power information transmitted periodically (every 15 seconds) from the sensor 4/5 is stored in the terminal storage unit 18. Because the storage device included in the mobile information terminal 6 has the capacity smaller than that of a storage device generally incorporated in the server, the first power information is deleted when a predetermined period expires. For example, the received pieces of first power information to two hours ago from the most recent clock time (the measurement clock time of the power) are stored in the terminal storage unit 18. That is, about 480 pieces of first power information on each one sensor of the most recent 2 hours are stored in the terminal storage unit 18 with a time step of the first period (15 seconds).

The instruction input unit 19 receives an instruction input of the user from input devices, such as a key, a button, and a touch panel, which are included in the mobile information terminal 6. The user manipulates the input device to issue the instruction to display the power information in the first or second period on the mobile information terminal 6 as the display period. In this case, the user's instruction includes the designation of the display period. The instruction input unit 19 outputs the received user's instruction (the information on the designated display period and the information on the designated sensor) to the information acquisition unit 20.

The information acquisition unit 20 acquires the first power information or the second power information based on the received user's instruction. Specifically, the information acquisition unit 20 acquires the first power information from the terminal storage unit 18 in the case that the power information in the designated display period is stored in the terminal storage unit 18. The information acquisition unit 20 issues the instruction to the terminal communication unit 17 to acquire the second power information from the server 9 in the case that the power information in the designated display period is not stored in the terminal storage unit 18. The information acquisition unit 20 outputs the first or second power information in the acquired and designated display period and the user's instruction to the display control unit 21.

The display control unit 21 controls the display unit 22 to display the received power information on the display unit 22, and presents the power information in the designated display period to the user.

The display unit 22 includes a display or the like, and displays the power information in the designated display period on the display.

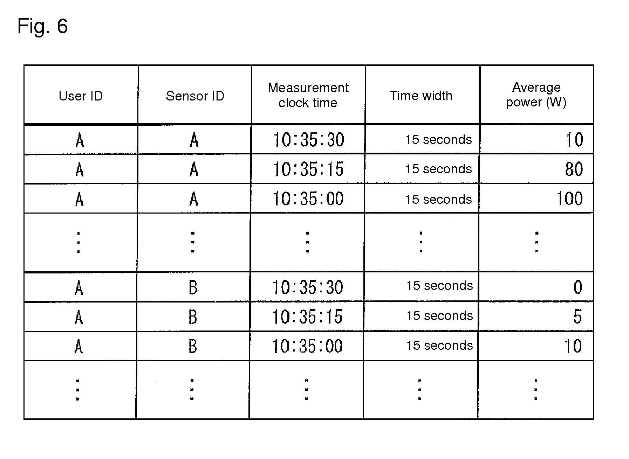

Fig. 6 is a view illustrating the first power information stored in the terminal storage unit 18. The pieces of first power information on the plurality of sensors are stored in the terminal storage unit 18 with respect to a certain user. The user ID, the sensor ID, the measurement clock time, the time width of the first period, and the average power of the first period are stored in the terminal storage unit 18 while correlated with one another.

### <Processing flow of sensor>

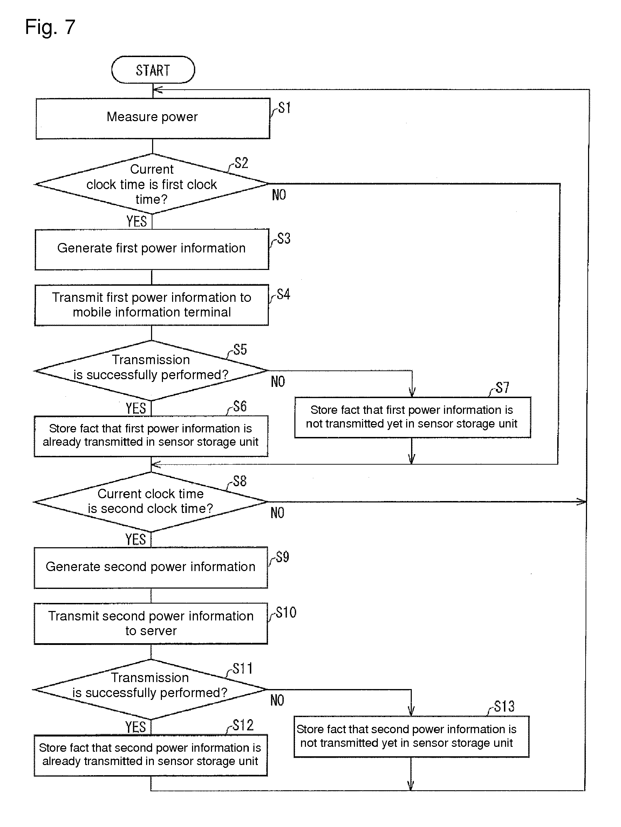

A processing flow in the sensor 4/5 will be described below. Fig. 7 is a flowchart illustrating the processing flow in the sensor 4/5.

The power measurement unit 11 measures the power of the electrical appliance 3 connected to the sensor 4/5 (S1). The power measurement unit 11 stores the data of the measured power in the sensor storage unit 12.

When a current clock time t is a first clock time (a predetermined clock time in each 15 seconds) (Yes in S2), the power information generation unit 13 acquires the data of the power in the most recent first period (for 15 seconds) from the sensor storage unit 12, obtains the average power in the first period, and generates the first power information (S3). For example, it is assumed that the average power of a clock time t1 to a clock time t2 (t2 = t1 + 15 [second]) is the first power information at the clock time t2, and that the average power of the clock time t2 to a clock time t3 (t3 = t2 + 15 [second]) is the first power information at the clock time t3. The power information generation unit 13 stores the generated first power information in the sensor storage unit 12.

The information transmission unit 14 transmits the first power information stored in the sensor storage unit 12 to the mobile information terminal 6 (S4). At this point, when the past first power information that cannot be transmitted to the mobile information terminal 6 due to a communication error and the like exists in the sensor storage unit 12, the first power information that is not transmitted yet is also transmitted to the mobile information terminal 6.

When the first power information is successfully transmitted (Yes in S5), the information transmission unit 14 stores the fact that the first power information at the clock time is already transmitted in the sensor storage unit 12 (S6). Alternatively, the already-transmitted first power information may be deleted from the sensor storage unit 12.

When failing to transmit the first power information (No in S5), the information transmission unit 14 stops transmission processing, and stores the fact that the first power information at the clock time is not transmitted yet in the sensor storage unit 12 (S7). For example, in the case that environment of the communication with the mobile information terminal 6 is degraded, or in the case that the user goes out while bringing the mobile information terminal 6, the information transmission unit 14 cannot conduct communication with the mobile information terminal 6.

The flow goes to the next processing, when the clock time t is not the first clock time (No in S2), or after S6 or S7.

When the clock time t is a second clock time (a predetermined clock time in each 10 minutes) (Yes in S8), the power information generation unit 13 acquires the data of the power in the most recent second period (for 10 minutes) from the sensor storage unit 12, obtains the average power in the second period, and generates the second power information (S9). For example, it is assumed that the average power of a clock time t4 to a clock time t5 (t5 = t4 + 10 [minute]) is the second power information at the clock time t5, and that the average power of the clock time t5 to a clock time t6 (t6 = t5 + 10 [minute]) is the second power information at the clock time t6. The power information generation unit 13 stores the generated second power information in the sensor storage unit 12.

The information transmission unit 14 transmits the second power information stored in the sensor storage unit 12 to the server 9 through the wireless LAN router 7 (S10). At this point, when the past second power information that cannot be transmitted to the server 9 due to the communication error and the like exists in the sensor storage unit 12, the second power information that is not transmitted yet is also transmitted to the server 9.

When the second power information is successfully transmitted (Yes in S11), the information transmission unit 14 stores the fact that the second power information at the clock time is already transmitted in the sensor storage unit 12 (S12). Alternatively, the already-transmitted second power information may be deleted from the sensor storage unit 12.

When failing to transmit the second power information (No in S11), the information transmission unit 14 stops the transmission processing, and stores the fact that the second power information at the clock time is not transmitted yet in the sensor storage unit 12 (S13). For example, in the case that environment of the communication with the wireless LAN router 7 is degraded, the information transmission unit 14 cannot conduct communication with the server 9.

The flow goes to the processing in S1, when the clock time t is not the second clock time (No in S8), or after S12 or S13.

### <Processing flow of mobile information terminal>

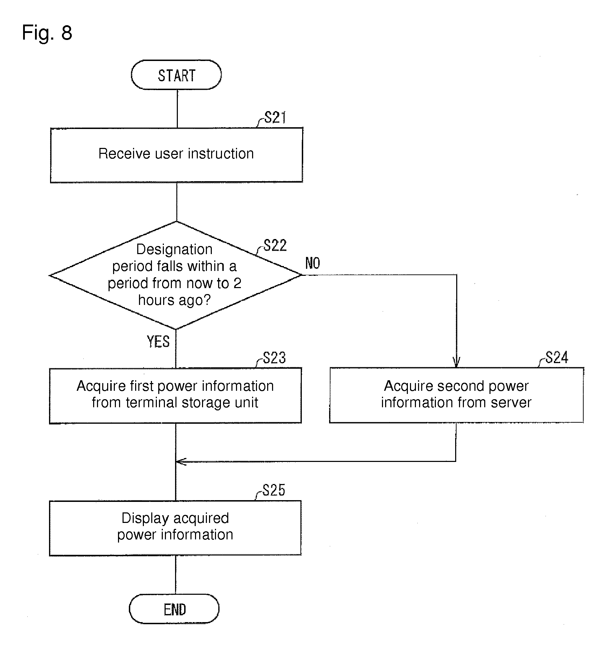

A processing flow in the mobile information terminal 6 will be described below. Fig. 8 is a flowchart illustrating the processing flow in the mobile information terminal 6.

The user inputs the instruction to display the power information into the instruction input unit 19 by manipulating the input devices, such as the key, the button, and the touch panel, which are included in the mobile information terminal 6. At this point, the user designates the display of the power information on the sensor 4/5 in the first or second period (the display period). For example, the user designates the display at a latest clock time tr and a display period length tl (for example, 2 hours, 1 day, or 1 month), and the period from the clock time (tr) to the clock time (tr+tl) may be set to the display period. A date may be designated instead of the clock time. Unless the user designates otherwise, it is assumed that the user issues the instruction to display the power information on a predetermined sensor in a predetermined period (for example, most recent two hours). The user may designate a scale of a vertical axis indicating the power information.

The instruction input unit 19 receives the instruction from the user (S21). The instruction input unit 19 outputs the user's instruction to the information acquisition unit 20. The user's instruction includes the sensor ID of the designated sensor 4/5 and the information on the designated display period.

Based on the received user's instruction, the information acquisition unit 20 selects (specifies) and acquires one of the first power information and the second power information.

When the designated display period falls within a period from the present moment to two hours ago (Yes in S22), the information acquisition unit 20 acquires the first power information on the designated sensor in the designated display period from the terminal storage unit 18 (S23). The pieces of first power information in the period from the most recent clock time to two hours ago are stored in the terminal storage unit 18. The first power information stored in the terminal storage unit 18 is the detailed power information having the small time step (every 15 seconds). Therefore, when the display period falls within the period from the present moment to two hours ago, the detailed power information (having the small time step) can be provided to the user using the first power information stored in the terminal storage unit 18. The information acquisition unit 20 acquires the power information presented to the user from the terminal storage unit 18 in the case that the power information on the designated sensor in the designated period can be expressed using the first power information stored in the terminal storage unit 18 (in the case that the power information on the designated sensor in the designated period exists in the terminal storage unit 18).

When the designated display period includes the period before two hours ago (No in S22), the information acquisition unit 20 outputs a command to acquire the second power information on the designated sensor in the designated display period to the terminal communication unit 17. The terminal communication unit 17 acquires the second power information on the designated sensor in the designated display period from the server 9 through the wireless LAN router 7 or wireless access point 10 (S24). The second power information stored in the server 9 is the power information having the large time step (every 10 minutes), and the pieces of second power information in the period from the most recent time clock to one year ago are stored in the server 9. Therefore, the pieces of power information in the period up to one year ago can be provided to the user. The information acquisition unit 20 acquires the power information presented to the user from the server 9 in the case that the power information on the designated sensor in the designated period cannot be expressed using the first power information stored in the terminal storage unit 18 (in the case that the power information on the designated sensor in the designated period does not exist in the terminal storage unit 18).

After S23 or S24, the display control unit 21 displays the acquired first or second power information on the display unit 22 (S25).

### <Display of power information>

When the user inputs the instruction to display the power information into the mobile information terminal 6, for example, the mobile information terminal 6 displays the power information in a default period (most recent two hours) of the main sensor 4. Because the pieces of power information for the most recent two hours are stored in the terminal storage unit 18 of the mobile information terminal 6, the mobile information terminal 6 reads the first power information from the terminal storage unit 18, and displays the first power information on the display unit 22.

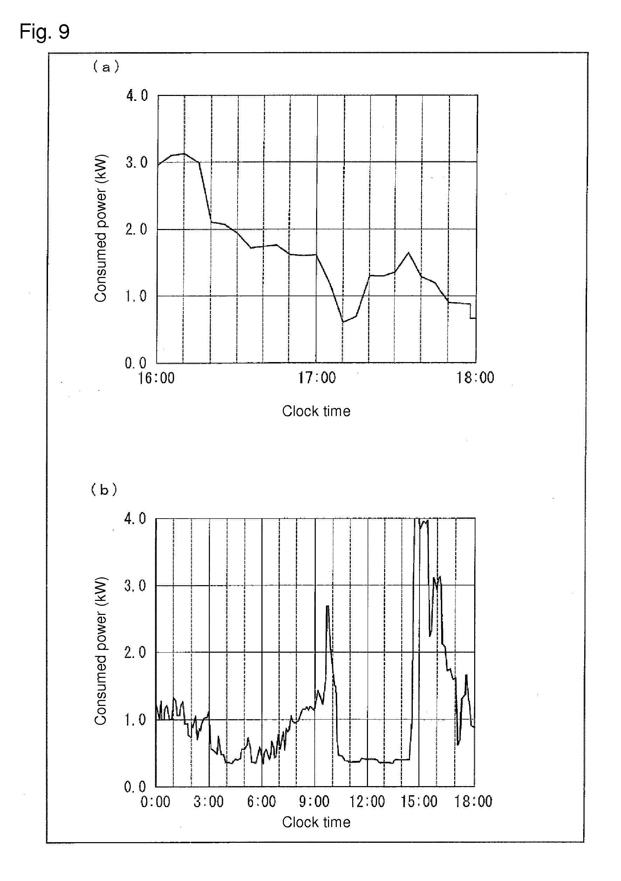

Fig. 9(a) is a view illustrating a display example of the power information on the last two hours. It is assumed that the clock time is 18:00. Because the mobile information terminal 6 has the detailed (in each 15 seconds) power information (the first power information) for the most recent two hours, the detailed change in power can be displayed. Because the information is rapidly updated, the decrease in consumed power can be checked as illustrated at the right end (around 18:00) in Fig. 9(a) even if "the television set is powered down one minute ago".

For example, when the user inputs the instruction to change the display period to most recent 18 hours into the mobile information terminal 6, because the power information before two hours ago is not stored in the terminal storage unit 18 of the mobile information terminal 6, the mobile information terminal 6 acquires the pieces of second power information for the most recent 18 hours from the server storage unit 16 of the server 9, and displays the pieces of second power information on the display unit 22.

Fig. 9(b) is a view illustrating a display example of the power information on the last 18 hours. Although only the pieces of power information (the pieces of second power information) having the time step of 10 minutes exist with respect to the period before two hours ago, the long-period change in consumed power can be presented to the user.

In the case that a graph of the power information in Figs. 9(a) and 9(b) is illustrated on a screen having a given size, a width of one hour of the displayed graph is shortened when the display period is lengthened as illustrated in Fig. 9(b). Therefore, the data having the fine time step is not required for the long display period. On the other hand, the width of one hour of the displayed graph is lengthened when the display period is shortened as illustrated in Fig. 9(a). For this reason, when the display period is shortened, the detailed data (having the fine time step) can be displayed in a given period (it is necessary to display the detailed data (having the fine time step) in the given period). In the power information providing system 1, the first power information having the fine time step is stored in the terminal storage unit 18 of the mobile information terminal 6, and the second power information having the coarse time step is stored in the server storage unit 16 of the server 9. Therefore, the power information suitable for the short display period is stored in the terminal storage unit 18, and the power information suitable for the long display period is stored in the server storage unit 16.

In the case that the mobile information terminal 6 is placed at a position where a radio wave hardly penetrates from the sensor 4/5, in the case that the mobile information terminal 6 is brought from the user's home, or in the case that the mobile information terminal 6 runs out of battery, the mobile information terminal 6 cannot receive the first power information that should be received from the sensor. For example, the mobile information terminal 6 preferentially acquires the power information from the terminal storage unit 18 thereof in order to display the pieces of power information for the most recent two hours, and the mobile information terminal 6 acquires the second power information in the corresponding period from the server 9 in the case that the power information in the corresponding period does not exist in the terminal storage unit 18. The user cannot acquire the detailed power information having the time step of 15 seconds from the outside. However, the user is satisfied with the coarse power information having the time step of 10 minutes, because the user cannot actively take the energy saving action while the user is out.

In the embodiment, the power information is transmitted from the sensor 4/5 to the mobile information terminal 6 at short intervals, and the power information is transmitted from the sensor 4/5 to the server 9 at longer intervals. When the user inputs the instruction to display the power information, the mobile information terminal 6 preferentially use the first power information stored in the terminal storage unit 18, and presents the power information to the user. In the case that the power information cannot be displayed on the condition (such as the display period and the time step) designated by the user using the first power information stored in the terminal storage unit 18, the mobile information terminal 6 acquires the second power information from the server 9 to present the power information to the user. Therefore, because the first power information is more frequently updated, the user can check the effect of the energy saving action with the mobile information terminal 6, and check the long-period power information using the second power information of the server 9. For example, because the user can check the latest consumed power information with the fine time step, the hard-to-realize effect of the reduction of the standby power can be presented to the user, and the motivation can be provided to the energy saving action of the user. Additionally, the communication load on the server 9 is suppressed to a low level, so that the server cost can be kept down. The information (the power information before predetermined time) that does not need to be frequently checked is stored in the large-capacity server storage unit 16 of the server 9. Therefore, the capacity of the terminal storage unit 18 of the mobile information terminal 6 is not wasted. The user can introduce the power information providing system 1 by placing the sensor 4/5 and installing the power information providing application on the mobile information terminal 6. There is no need to individually prepare dedicated device such as the server, so that the power information providing system 1 can be introduced at low cost.

### <Other modifications>

The present invention may be applied to a building or a factory, to measure the powers of instruments in the building or the powers of facilities in the factory, and transmit the measured powers to the mobile information terminal and the server.

In the system of the above described embodiment, the power of the electrical appliance is measured and presented to the user. Alternatively, instead of the power, any physical quantity that changes with time is measured, and the information on the physical quantity may be presented to the user. For example, the sensor may measure a temperature at a position of the electrical appliance, and transmit the temperature information to the mobile information terminal and the server.

The sensor may transmit the second power information to not only the server but also the mobile information terminal. The mobile information terminal may retain the second power information within an allowable range of the capacity of the terminal storage unit. When the mobile information terminal has the second power information, using the small capacity of the terminal storage unit, the long-period power information can rapidly be presented to the user without accessing the server although the data is coarse.

The sensor may generate third power information having the time step coarser than that of the second power information, and transmit the third power information to the mobile information terminal. The third power information has the coarse time step, the mobile information terminal can retain the long-period power information (before two hours ago) using the small capacity of the terminal storage unit. In the case that the user issues the instruction to display the power information in the period before two hours ago, a comfort level of the user can be improved by presenting the third power information having the coarse time step to the user while the mobile information terminal acquires the second power information from the server.

For example, the sensor may obtain the average power every 5 seconds in the first period (for 15 seconds), and transmits the three average power values as the power information indicating the power in the first period to the mobile information terminal in each first period (every 15 seconds). The same holds true for the second power information transmitted to the server. A cycle in which the average power is obtained to generate the first (or second) power information may differ from a cycle in which the first (or second) power information is transmitted to the mobile information terminal (or the server).

The display control unit may simultaneously display the two kinds of pieces of power information having the fine time step and the coarse time step to the display unit based on the instruction from the user.

The present invention may be expressed as follows.

In accordance with a first aspect of the present invention, a physical-quantity information providing system that provides physical-quantity information to a user, the physical-quantity information indicating a physical quantity changing with time, the physical-quantity information providing system includes: a first storage unit in which the physical-quantity information in a first period is stored; a second storage unit in which the physical-quantity information in a second period different from the first period is stored; an instruction input unit that receives a designation of a display period from the user, the designation of the display period indicating display of the physical-quantity information in the first or second period; an information acquisition unit that specifies acquisition of the physical-quantity information from the first or second storage unit according to the display period designated by the user, and acquires the physical-quantity information from the specified storage unit; and a display control unit that controls the display of the physical-quantity information acquired by the information acquisition unit.

In accordance with a second aspect of the present invention, a physical-quantity information providing method of providing physical-quantity information to a user, the physical-quantity information indicating a physical quantity changing with time, the physical-quantity information providing method includes: a first storage step of storing the physical-quantity information in a first period in a first storage unit; a second storage step of storing the physical-quantity information in a second period different from the first period in a second storage unit; an instruction input step of receiving a designation of a display period from the user, the designation of the display period indicating display of the physical-quantity information in the first or second period; an information acquisition step of specifying acquisition of the physical-quantity information from the first or second storage unit according to the display period designated by the user, and acquiring the physical-quantity information from the specified storage unit; and a display control step of controlling the display of the physical-quantity information acquired in the information acquisition step.

In accordance with a third aspect of the present invention, a mobile information terminal that can conduct communication with a measurement apparatus and an information processing apparatus, the mobile information terminal includes: a receiving unit that receives physical-quantity information from the measurement apparatus, the physical-quantity information indicating a physical quantity measured by the measurement apparatus; a first storage unit in which the received physical-quantity information is stored; an instruction input unit that receives a designation of a display period from the user, the designation of the period indicating display of the physical-quantity information in the period; an information acquisition unit that specifies acquisition of the physical-quantity information from the first storage unit or a second storage unit included in the information processing apparatus according to the display period designated by the user, and acquires the physical-quantity information from the specified storage unit; and a display control unit that controls the display of the physical-quantity information acquired by the information acquisition unit.

In accordance with a fourth aspect of the present invention, a method of controlling a mobile information terminal that can conduct communication with a measurement apparatus and an information processing apparatus, the mobile information terminal controlling method includes: a receiving step of receiving physical-quantity information from the measurement apparatus, the physical-quantity information indicating a physical quantity measured by the measurement apparatus; a first storage step of storing the received physical-quantity information in a first storage unit included in the mobile information terminal; an instruction input step of receiving a designation of a display period from the user, the designation of the display period indicating display of the physical-quantity information in the designated period; an information acquisition step of specifying acquisition of the physical-quantity information from the first storage unit or a second storage unit included in the information processing apparatus according to the display period designated by the user, and acquiring the physical-quantity information from the specified storage unit; and a display control step of controlling the display of the physical-quantity information acquired in the information acquisition step.

In accordance with a fifth aspect of the present invention, a measurement apparatus that can conduct communication with a mobile information terminal and an information processing apparatus, the measurement apparatus includes: a physical-quantity measurement unit that measures a physical quantity changing with time; a physical-quantity information generation unit that generates physical-quantity information indicating the physical quantity; and an information transmission unit that transmits the physical-quantity information to the mobile information terminal in each third period, and transmits the physical-quantity information to the information processing apparatus in each fourth period longer than the third period.

In accordance with a sixth aspect of the present invention, a method of controlling a measurement apparatus that can conduct communication with a mobile information terminal and an information processing apparatus, the measurement apparatus controlling method includes: a physical-quantity measurement step of measuring a physical quantity changing with time; a physical-quantity information generation step of generating physical-quantity information indicating the physical quantity; and an information transmission step of transmitting the physical-quantity information to the mobile information terminal in each third period, and transmitting the physical-quantity information to the information processing apparatus in each fourth period longer than the third period.

According to the configuration, the first storage unit in which the physical-quantity information in the first period is stored and the second storage unit in which the physical-quantity information in the second period is stored can share roles. Therefore, one of the storage units can be used as means for storing the last physical-quantity information while the other storage unit is used as means for storing the past physical-quantity information. For this reason, for example, when one of the storage units is incorporated in the mobile information terminal while the other storage unit is incorporated in the information processing apparatus, a communication load on the information processing apparatus can be reduced. Therefore, the introduction cost of the physical-quantity information providing system can be reduced.

The physical-quantity information providing system may have a configuration in which the physical-quantity information is stored in the first storage unit only in the first period, the physical-quantity information is stored in the second storage unit only in the second period, the second period is longer than the first period, and the information acquisition unit acquires preferentially the physical-quantity information from the first storage unit, and acquires the physical-quantity information from the second storage unit when the physical-quantity information in the display period designated by the user is not stored in the first storage unit.

According to the configuration, for example, when the first storage units is incorporated in the mobile information terminal while the second storage unit is incorporated in the information processing apparatus, the communication load on the information processing apparatus can be reduced. Therefore, the introduction cost of the physical-quantity information providing system can be reduced.

The physical-quantity information providing system may further include: a measurement apparatus; a mobile information terminal; and information processing apparatus, wherein the measurement apparatus includes: a physical-quantity measurement unit that measures the physical quantity; a physical-quantity information generation unit that generates the physical-quantity information from the measured physical quantity; and an information transmission unit that transmits the physical-quantity information to the mobile information terminal in each third period, and transmits the physical-quantity information to the information processing apparatus in each fourth period longer than the third period, the information processing apparatus includes the second storage unit in which the physical-quantity information received from each of the plurality of measurement apparatuses is stored, and the mobile information terminal includes: the first storage unit in which the physical-quantity information received from the measurement apparatus is stored; the instruction input unit; the information acquisition unit; and the display control unit.

According to the configuration, the information transmission unit of the measurement apparatus transmits the physical-quantity information to the mobile information terminal in each third period, and transmits the physical-quantity information to the information processing apparatus in each fourth period longer than the third period. The physical-quantity information updated more frequently is stored in the first storage unit of the mobile information terminal. Therefore, the user can instantly check the variation in physical quantity by the first storage unit of the mobile information terminal. The communication load on the information processing apparatus can be reduced.

The second storage unit may be configured such that the physical-quantity information received from each of the plurality of measurement apparatuses of different users is stored therein.

According to the configuration, it is not necessary for the user to prepare the dedicated information processing apparatus, so that the introduction cost of the physical-quantity information providing system can be reduced. The first storage unit and the second storage unit share roles, so that the communication load on the information processing apparatus can also be reduced.

The physical quantity may be the current, voltage or power of the electrical appliance.

According to the configuration, the user can rapidly check the power of the electrical appliance.

The physical-quantity information providing system may have a configuration in which a time step of the physical-quantity information stored in the first storage unit is finer than a time step of the physical-quantity information stored in the second storage unit.

According to the configuration, the first storage unit has the physical-quantity information suitable for the display in the case that the user designates the short display period, and the second storage unit has the physical-quantity information suitable for the display in the case that the user designates the long display period. Therefore, the information acquisition unit can selectively acquire the physical-quantity information from the first storage unit or the second storage unit according to the display period designated by the user.

### (Program and recording medium)

The physical-quantity information providing system, the measurement apparatus, and the mobile information terminal may partially be constructed by a computer. In this case, the present invention also includes a control program that causes a computer to operate as each unit of the physical-quantity information providing system, the measurement apparatus, and the mobile information terminal and a computer-readable recording medium in which the control program is recorded.

Each block of the sensor 4/5, the mobile information terminal 6, and the server 9, particularly the power measurement unit 11, the power information generation unit 13, the information transmission unit 14, the server communication unit 15, the terminal communication unit 17, the instruction input unit 19, the information acquisition unit 20, and the display control unit 21 may be constructed by a hardware logic, or by software using a CPU (Central Processing Unit).

That is, the sensor 4/5, the mobile information terminal 6, and the server 9 include the CPU that executes a command of a control program implementing each function, a ROM (Read Only Memory) in which the control program is stored, a RAM (Random Access Memory) in which the control program is expanded, and storage devices (recording medium), such as a memory, in which the control program and various pieces of data are stored. The object of the present invention can also be achieved such that the recording medium in which a program code (an executable format program, an intermediate code program, and a source program) of the control program for each of the sensor 4/5, the mobile information terminal 6, and the server 9, which is of the software implementing the above functions, is stored while being readable by a computer is supplied to the sensor 4/5, the mobile information terminal 6, and the server 9, and such that the computer (or the CPU or an MPU (Micro Processor Unit)) reads and executes the program code recorded in the recording medium.

Examples of the recording medium include tape systems, such as a magnetic tape and a cassette tape, disk systems including magnetic disks such as a floppy disk (registered trademark) and a hard disk, and optical disks such as a CD-ROM (Compact Disc Read-Only Memory), an MO (Magneto-Optical), an MD (Mini Disc), a DVD (Digital Versatile Disk), and a CD-R (CD Recordable), card systems, such as an IC card (including a memory card) and an optical card, and semiconductor memory systems, such as a mask ROM, an EPROM (Erasable Programmable Read-Only Memory), an EEPROM (Electrically Erasable and Programmable Read-Only Memory), and a flash ROM.

The sensor 4/5, the mobile information terminal 6, and the server 9 may be configured to be able to be connected to a communication network, and the program code may be supplied through the communication network. There is no particular limitation to the communication network. Examples of the communication network include the Internet, an intranet, an extranet, a LAN (Local Area Network), an ISDN (Integrated Services Digital Network), a VAN (Value-Added Network), a CATV (Community Antenna TeleVision) communication network, a virtual private network, a telephone line network, a mobile communication network, and a satellite communication network. There is no particular limitation to a transmission medium constituting the communication network. Examples of the transmission medium include wired lines, such as IEEE (Institute of Electrical and Electronic Engineers) 1394, a USB, a power-line carrier, a cable TV line, a telephone line, and an ADSL (Asynchronous Digital Subscriber Loop) line, and wireless lines, such as infrared rays, such as IrDA (Infrared Data Association) and a remote controller, Bluetooth (registered trademark), 802.11 wireless, HDR (High Data Rate), a mobile phone network, a satellite line, and a terrestrial digital network.

The present invention is not limited to the embodiment, but various changes can be made without departing from the scope of the present invention. That is, an embodiment obtained by a combination of technical means, which are properly changed without departing from the scope of the present invention, is also included in the technical scope of the present invention.

### INDUSTRIAL APPLICABILITY

The present invention can be applied to the power information providing system.

### DESCRIPTION OF SYMBOLS

- 1: power information providing system (physical-quantity information providing system)
- 2: breaker
- 3: electrical appliance
- 4: main sensor (measurement apparatus)
- 5: sub-sensor (measurement apparatus)
- 6: mobile information terminal
- 7: wireless LAN router
- 8: the Internet (network)
- 9: server (information processing apparatus)
- 10: wireless access point
- 11: power measurement unit (physical-quantity measurement unit)
- 12: sensor storage unit
- 13: power information generation unit (physical-quantity information generation unit)
- 14: information transmission unit
- 15: server communication unit
- 16: server storage unit
- 17: terminal communication unit (receiving unit)
- 18: terminal storage unit
- 19: instruction input unit
- 20: information acquisition unit
- 21: display control unit
- 22: display unit

## Claims

1. A physical-quantity information providing system that provides physical-quantity information to a user, the physical-quantity information indicating a physical quantity changing with time, the physical-quantity information providing system comprising:
a first storage unit in which the physical-quantity information in a first period is stored;
a second storage unit in which the physical-quantity information in a second period different from the first period is stored;
an instruction input unit that receives a designation of a display period from the user, the designation of the display period indicating display of the physical-quantity information in the first or second period;
an information acquisition unit that specifies acquisition of the physical-quantity information from the first or second storage unit according to the display period designated by the user, and acquires the physical-quantity information from the specified storage unit; and
a display control unit that controls the display of the physical-quantity information acquired by the information acquisition unit.

2. The physical-quantity information providing system according to claim 1, wherein the physical-quantity information is stored in the first storage unit only in the first period,
the physical-quantity information is stored in the second storage unit only in the second period,
the second period is longer than the first period, and
the information acquisition unit acquires preferentially the physical-quantity information from the first storage unit, and acquires the physical-quantity information from the second storage unit when the physical-quantity information in the display period designated by the user is not stored in the first storage unit.

3. The physical-quantity information providing system according to claim 1 or 2, further comprising: a measurement apparatus; a mobile information terminal; and information processing apparatus,
wherein the measurement apparatus includes:
a physical-quantity measurement unit that measures the physical quantity;
a physical-quantity information generation unit that generates the physical-quantity information from the measured physical quantity; and
an information transmission unit that transmits the physical-quantity information to the mobile information terminal in each third period, and transmits the physical-quantity information to the information processing apparatus in each fourth period longer than the third period,
the information processing apparatus includes the second storage unit in which the physical-quantity information received from each of the plurality of measurement apparatuses is stored, and
the mobile information terminal includes:
the first storage unit in which the physical-quantity information received from the measurement apparatus is stored;
the instruction input unit;
the information acquisition unit;
and the display control unit.

4. The physical-quantity information providing system according to claim 1 or 2, wherein a time step of the physical-quantity information stored in the first storage unit is finer than a time step of the physical-quantity information stored in the second storage unit.

5. A mobile information terminal that can conduct communication with a measurement apparatus and an information processing apparatus, the mobile information terminal comprising:
a receiving unit that receives physical-quantity information from the measurement apparatus, the physical-quantity information indicating a physical quantity measured by the measurement apparatus;
a first storage unit in which the received physical-quantity information is stored;
an instruction input unit that receives a designation of a display period from the user, the designation of the period indicating display of the physical-quantity information in the period;
an information acquisition unit that specifies acquisition of the physical-quantity information from the first storage unit or a second storage unit included in the information processing apparatus according to the display period designated by the user, and acquires the physical-quantity information from the specified storage unit; and
a display control unit that controls the display of the physical-quantity information acquired by the information acquisition unit.

6. A measurement apparatus that can conduct communication with a mobile information terminal and an information processing apparatus, the measurement apparatus comprising:
a physical-quantity measurement unit that measures a physical quantity changing with time;
a physical-quantity information generation unit that generates physical-quantity information indicating the physical quantity; and
an information transmission unit that transmits the physical-quantity information to the mobile information terminal in each third period, and transmits the physical-quantity information to the information processing apparatus in each fourth period longer than the third period.

7. A physical-quantity information providing method of providing physical-quantity information to a user, the physical-quantity information indicating a physical quantity changing with time, the physical-quantity information providing method comprising:
a first storage step of storing the physical-quantity information in a first period in a first storage unit;
a second storage step of storing the physical-quantity information in a second period different from the first period in a second storage unit;
an instruction input step of receiving a designation of a display period from the user, the designation of the display period indicating display of the physical-quantity information in the first or second period;
an information acquisition step of specifying acquisition of the physical-quantity information from the first or second storage unit according to the display period designated by the user, and acquiring the physical-quantity information from the specified storage unit; and
a display control step of controlling the display of the physical-quantity information acquired in the information acquisition step.

8. A method of controlling a mobile information terminal that can conduct communication with a measurement apparatus and an information processing apparatus, the mobile information terminal controlling method comprising:
a receiving step of receiving physical-quantity information from the measurement apparatus, the physical-quantity information indicating a physical quantity measured by the measurement apparatus;
a first storage step of storing the received physical-quantity information in a first storage unit included in the mobile information terminal;
an instruction input step of receiving a designation of a display period from the user, the designation of the display period indicating display of the physical-quantity information in the designated period;
an information acquisition step of specifying acquisition of the physical-quantity information from the first storage unit or a second storage unit included in the information processing apparatus according to the display period designated by the user, and acquiring the physical-quantity information from the specified storage unit; and
a display control step of controlling the display of the physical-quantity information acquired in the information acquisition step.

9. A method of controlling a measurement apparatus that can conduct communication with a mobile information terminal and an information processing apparatus, the measurement apparatus controlling method comprising:
a physical-quantity measurement step of measuring a physical quantity changing with time;
a physical-quantity information generation step of generating physical-quantity information indicating the physical quantity; and
an information transmission step of transmitting the physical-quantity information to the mobile information terminal in each third period, and transmitting the physical-quantity information to the information processing apparatus in each fourth period longer than the third period.

10. A control program that causes a computer to execute a physical-quantity information providing system, the physical-quantity information providing system providing physical-quantity information to a user, the physical-quantity information indicating a physical quantity changing with time, the control program comprising:
a first storage step of storing the physical-quantity information in a first period in a first storage unit;
a second storage step of storing the physical-quantity information in a second period different from the first period in a second storage unit;
an instruction input step of receiving a designation of a display period from the user, the designation of the display period indicating display of the physical-quantity information in the first or second period;
an information acquisition step of specifying acquisition of the physical-quantity information from the first or second storage unit according to the display period designated by the user, and acquiring the physical-quantity information from the specified storage unit; and
a display control step of controlling the display of the physical-quantity information acquired in the information acquisition step.

11. A control program that causes a computer to execute a mobile information terminal, the mobile information terminal being able to conduct communication with a measurement apparatus and an information processing apparatus, the control program comprising:
a receiving step of receiving physical-quantity information from the measurement apparatus, the physical-quantity information indicating a physical quantity measured by the measurement apparatus;
a first storage step of storing the received physical-quantity information in a first storage unit included in the mobile information terminal;
an instruction input step of receiving a designation of a display period from the user, the designation of the display period indicating display of the physical-quantity information in the designated period;
an information acquisition step of specifying acquisition of the physical-quantity information from the first storage unit or a second storage unit included in the information processing apparatus according to the display period designated by the user, and acquiring the physical-quantity information from the specified storage unit; and
a display control step of controlling the display of the physical-quantity information acquired in the information acquisition step.

12. A control program that causes a computer to execute a measurement apparatus, the measurement apparatus being able to conduct communication with a mobile information terminal and an information processing apparatus, the control program comprising:
a physical-quantity measurement step of measuring a physical quantity changing with time;
a physical-quantity information generation step of generating physical-quantity information indicating the physical quantity; and
an information transmission step of transmitting the physical-quantity information to the mobile information terminal in each third period, and transmitting the physical-quantity information to the information processing apparatus in each fourth period longer than the third period.
